# EUROPEAN PATENT APPLICATION

(11) **EP 2 143 818 A1**
(43) Date of publication of application: **13.01.2010**
(21) Application number: 08740375.4
(22) Date of filing: 14.04.2008
(51) Int. Cl.: C23C 14/12, C08F 16/38, C08F 24/00, C08F 34/02, C23C 14/24

(54) **FLUORINE-CONTAINING POLYMER THIN FILM AND METHOD FOR PRODUCING THE SAME**

(30) Priority: 20.04.2007 JP 2007112141; 18.09.2007 JP 2007241155
(71) Applicant: Asahi Glass Company, Limited, Chiyoda-ku Tokyo 100-8405 (JP)
(72) Inventor: TAMITSUJI, Chikaya, Tokyo 100-8405 (JP); WATANABE, Kunio, Tokyo 100-8405 (JP); SAKANE, Yoshihiko, Tokyo 100-8405 (JP); MINAMIDATE, Jun, Tokyo 100-8405 (JP)
(74) Representative: Müller-Boré & Partner Patentanwälte
(86) International application number: PCT/JP2008/057287
(87) International publication number: WO 2008/133088

(57) **Abstract**

To provide a method for producing a fluoropolymer excellent in adhesion to a substrate and film strength.

A method for producing a fluoropolymer thin film, which comprises forming a fluoropolymer thin film on a substrate by a physical vapor deposition method using, as an evaporation source, a fluoropolymer having a fluorinated aliphatic ring structure in its main chain and having a weight average molecular weight of from 3,000 to 80,000.

## Description

### TECHNICAL FIELD

The present invention relates to a fluoropolymer thin film, particularly a fluoropolymer thin film having a fluorinated aliphatic ring structure, and a method for its production.

### BACKGROUND ART

Fluoropolymers represented by polytetrafluoroethylene (PTFE), a tetrafluoroethylene/perfluoro(alkoxy vinyl ether) copolymer (PFA), a tetrafluoroethylene/hexafluoropropylene copolymer (FEP), polyvinylidene fluoride (PVDF), etc., are excellent in heat resistance, chemical resistance, water repellency, weather resistance, electrical insulating properties, optical properties, non-adhesive properties, low frictional properties, flame retardancy, etc., and by virtue of such properties, they are used in various fields, such as chemical, electrical, electronical, semiconductor, architectural and automobile fields.

In recent years, along with developments in microfabrication technology such as semiconductor production technology, MEMS process technology or nanoimprinting technology, in the production of semiconductors or electronic equipments, a technique has been desired to form a uniform fluoropolymer thin film free from pinholes, on a substrate surface having a fine structure and to impart chemical resistance, water-proofing property, moisture-proofing property, release property, etc.

As a method for forming a fluoropolymer thin film, a wet method such as a spin coating method, a casting method or a dipping method has been known. However, due to the viscosity of the liquid containing such a fluoropolymer, there is a problem such that it is very difficult to form a uniform fluoropolymer thin film free from pinholes, on the substrate surface having a fine structure.

On the other hand, in the formation of a thin film by a dry method, it is generally considered that the mean free path of gaseous molecules as a raw material for forming a thin film, is large, such molecules of gas will uniformly reach into the structure having a fine structure, and as compared with the wet system, it is thereby expected to be possible to form a uniform thin film free from pinholes, on the substrate surface having such a fine structure.

As a method of forming a fluoropolymer thin film by a dry method, a method of forming a thin film of polytetrafluoroethylene (PTFE) on a substrate surface by means of a sputtering method has been disclosed (e.g. Non-Patent Document 1). Further, a method of forming a fluoropolymer thin film on a substrate surface by a vacuum evaporation method is known. Usually, in a case where a fluoropolymer thin film is formed by a vacuum evaporation method, a fluoropolymer as the evaporation source is vaporized by applying a high energy via electron beams, ion beams or heat. However, by application of such a high energy in the process of physical vapor deposition, fluorine atoms in the fluoropolymer are likely to be eliminated, and the fluorine content in the fluoropolymer thin film thereby formed is likely to be substantially low as compared with the fluorine content in the evaporation source. As the results, there will be problems such that the fluoropolymer thin film thereby formed tends to be colored, and the properties of the fluoropolymer thin film tend to be low. Further, there will be problems such that the main chain of the fluoropolymer is likely to be cleaved, and the molecular weight will be thereby decreased. Consequently, the film strength of the fluoropolymer thin film thereby obtained, and the adhesion of the thin film to the substrate, will be low.

In order to solve the above problems, as a method for producing a fluoropolymer thin film by means of a vacuum evaporation method, a method to form a film by using a more readily vaporizable fluoropolymer evaporation source as the raw material or a method to introduce a second component in order to improve the adhesion with the substrate, has been proposed, as described below.
(1) A method for producing a fluoropolymer thin film, which comprises forming a film by a physical vapor deposition method using, as an evaporation source, a copolymer of tetrafluoroethylene with at least one comonomer (Patent Document 1).
(2) A method for forming a fluororesin-covering film, which comprises covering a substrate with a fluororesin by a vacuum plating method by using, as a target material, a fluororesin having a low molecular weight i.e. an average molecular weight within a range of from 600 to 1,500 (Patent Document 2).
(3) A method for producing a substrate having a fluorinated thin film, which comprises depositing a fluoroorganic substance by a vapor deposition method and a non-fluorinated substance by an ion beam sputtering method simultaneously on a substrate surface (Patent Document 3).

The method disclosed in Patent Document 1 is a method wherein a copolymer of a tetrafluoroethylene with at least one comonomer is used as an evaporation source to lower crystallinity of the polymer and to increase the vapor pressure, and in Examples, Teflon (registered trademark) AF (manufactured by Du Pont) is vapor-deposited at a temperature of from 450 to 470°C. However, Teflon (registered trademark) AF (manufactured by Du Pont) starts thermal decomposition at a temperature of about 350°C (Non-Patent Document 2), and in the case of a fluoropolymer thin film to be formed by vapor deposition at a high temperature exceeding the thermal decomposition temperature, there has been a problem that the molecular weight of the fluoropolymer decreases, and the film strength tends to be low.

The method disclosed in Patent Document 2 is a method wherein a fluororesin (fluoropolymer) having a low molecular weight i.e. an average molecular weight within a range of from 600 to 1,500, is used as a target material, thereby to increase the vapor pressure of the fluoropolymer and wherein a film may be formed at a relatively low temperature of from 250 to 300°C. However, since the molecular weight of the fluororesin (fluoropolymer) as an evaporation source is low, the molecular weight of the formed fluoropolymer thin film tends to be small, and the strength of the fluoropolymer thin film tends to be low. Further, no chemical bond to the substrate will be formed, whereby there has been a problem that the adhesion to the substrate is poor, and the film tends to be easily peeled.

The method disclosed in Patent Document 3 is such that if a film is formed on a substrate surface by a vapor deposition method of a fluoroorganic substance alone, the film strength tends to be inadequate, and therefore, a non-fluorinated substance as a second component is simultaneously deposited by an ion beam sputtering method to have the formed film composited thereby to improve the film strength. However, since a second component such as SiO₂ is introduced, there has been a problem that the properties of the fluoropolymer thin film tend to be low.
Non-Patent Document 1: Thin Solid Films, 15, p87 (1973)
Non-Patent Document 2: Modern Fluoropolymers, 22, p411 (1997)
Patent Document 1: JP-A-04-006266
Patent Document 2: JP-A-01-304936
Patent Document 3: JP-A-2006-001014

### DISCLOSURE OF THE INVENTION

### OBJECT TO BE ACCOMPLISHED BY THE INVENTION

In order to solve the above-mentioned problems of the prior art, it is an object of the present invention to provide a method for forming a fluoropolymer thin film excellent in the film strength and adhesion to a substrate.

### MEANS TO ACCOMPLISH THE OBJECT

In order to accomplish the above object, the present invention provides a method for producing a fluoropolymer thin film, which comprises forming a fluoropolymer thin film on a substrate by a physical vapor deposition method using, as an evaporation source, a fluoropolymer having a fluorinated aliphatic ring structure in its main chain and having a weight average molecular weight of from 3,000 to 80,000.

In the method for producing a fluoropolymer thin film of the present invention, the fluoropolymer having a fluorinated aliphatic ring structure in its main chain is preferably a fluoropolymer having a repeating unit selected from the following formulae (1) to (5): 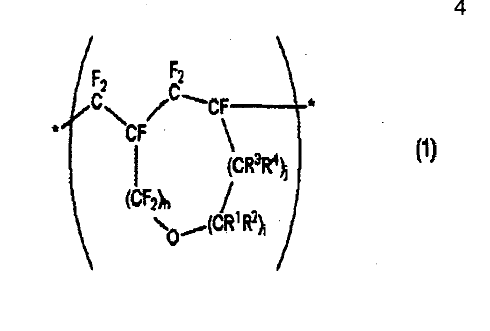 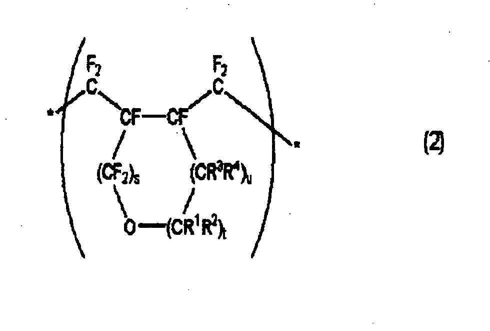 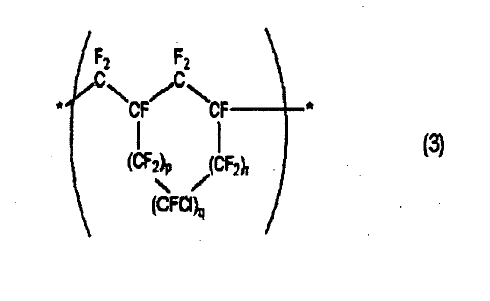 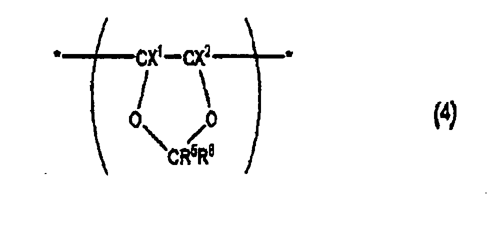 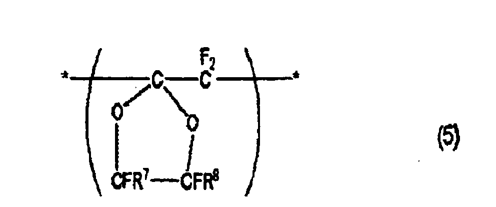 in the formulae (1) to (5), h is an integer of from 0 to 5, i is an integer of from 0 to 4, j is 0 or 1, h+i+j is from 1 to 6, s is an integer of from 0 to 5, t is an integer of from 0 to 4, u is 0 or 1, s+t+u is from 1 to 6, each of p, q and r which are independent of one another, is an integer of from 0 to 5, p+q+r is from 1 to 6, each of R¹, R², R³, R⁴, X¹ and X² which are independent of one another, is H, D (deuterium), F, Cl, OCF₃ or CF₃, each of R⁵, R⁶, R⁷ and R⁸ which are independent of one another, is H, D (deuterium), F, Cl, CₙF₂ₙ₊₁, CₙF₂ₙ₊₁₋ₘClₘOₖ or CₙF₂ₙ₊₁₋ₘHₘOₖ, at least one of R⁵, R⁶, X¹ and X² contains F, n is an integer of from 1 to 5, m is an integer of from 0 to 5, 2n+1-m≧0, k is an integer of 0 or 1, and R⁷ and R⁸ may be connected to form a ring.

In the method for producing a fluoropolymer thin film of the present invention, the fluoropolymer having a fluorinated aliphatic ring structure in its main chain is preferably a perfluoropolymer, more preferably a perfluorohomopolymer.

In the method for producing a fluoropolymer thin film of the present invention, the fluoropolymer having a fluorinated aliphatic ring structure in its main chain is preferably any one of the following fluoropolymers (I) to (V):
(I)a fluoropolymer having repeating units formed by cyclopolymerization of a fluoromonomer (a) having at least 2 polymerizable double bonds,
(II) a fluoropolymer having repeating units formed by polymerization of a fluoromonomer (b) having a fluorinated ring structure,
(III) a fluoropolymer having repeating units formed by cyclopolymerization of the above fluoromonomer (a) and repeating units formed by polymerization of the above fluoromonomer (b),
(IV) a fluoropolymer having repeating units formed by cyclopolymerization of the above fluoromonomer (a) and repeating units formed by polymerization of a fluoromonomer (c) other than the above fluoromonomer (a) or (b), and
(V) a fluoropolymer having repeating units formed by polymerization of the above fluoromonomer (b) and repeating units formed by polymerization of a fluoromonomer (c) other than the above fluoromonomer (a) or (b).

In the method for producing a fluoropolymer thin film of the present invention, the physical vapor deposition method is preferably a vacuum evaporation method.

In the vacuum evaporation method, the heating temperature of the evaporation source is preferably within a range of from 100 to 400°C.

Further, the present invention provides a fluoropolymer thin film having a thickness of from 10 nm to 100 µm, obtainable by the method for producing a fluoropolymer thin film of the present invention.

### ADVANTAGEOUS EFFECTS OF THE INVENTION

According to the present invention, it is possible to produce a fluoropolymer thin film excellent in the film strength and adhesion to a substrate. The present invention is particularly suitable for forming a fluoropolymer thin film on a substrate surface having a fine structure.

### BEST MODE FOR CARRYING OUT THE INVENTION

Now, the present invention will be described in detail.

The method for producing a fluoropolymer thin film of the present invention comprises forming a fluoropolymer thin film on a substrate by a physical vapor deposition method using, as an evaporation source, a fluoropolymer having a fluorinated aliphatic ring structure in its main chain and having a weight average molecular weight of from 3,000 to 80,000.

### FLUOROPOLYMER EVAPORATION SOURCE

In the present invention, the evaporation source of the fluoropolymer is required to have a sufficient vapor pressure for practical use from the viewpoint of the film forming rate. From this viewpoint, a fluoropolymer having a fluorinated aliphatic ring structure in its main chain and having a low crystallinity, is used. As the fluoropolymer having a fluorinated aliphatic ring structure in its main chain, one having a repeating unit having a fluorinated aliphatic ring structure in its main chain, selected from the following formulae (1) to (5), may, for example, be mentioned. 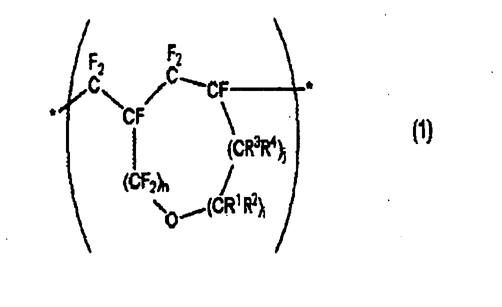 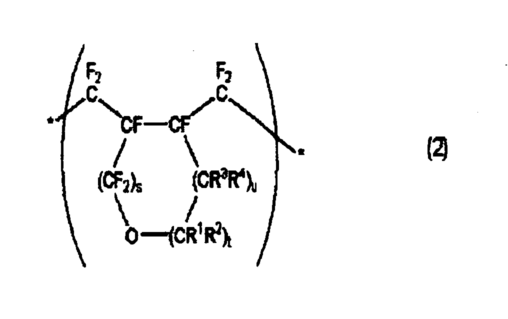 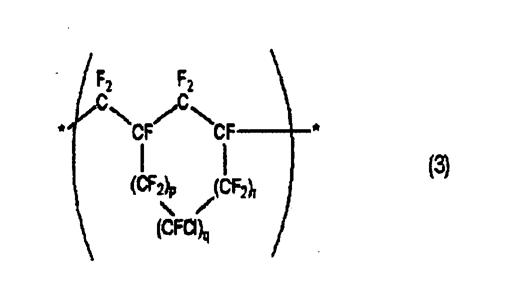 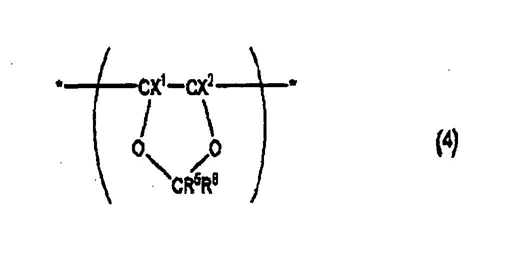 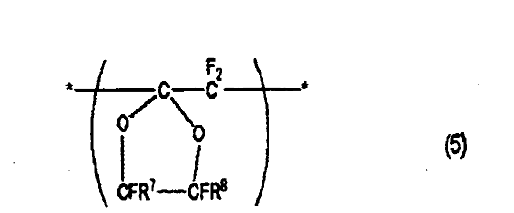 in the formulae (1) to (5), h is an integer of from 0 to 5, i is an integer of from 0 to 4, j is 0 or 1, h+i+j is from 1 to 6, s is an integer of from 0 to 5, t is an integer of from 0 to 4, u is 0 or 1, s+t+u is from 1 to 6, each of p, q and r which are independent of one another, is an integer of from 0 to 5, p+q+r is from 1 to 6, each of R¹, R², R³, R⁴, X¹ and X² which are independent of one another, is H, D (deuterium), F, Cl, OCF₃ or CF₃, each of R⁵, R⁶, R⁷ and R⁸ which are independent of one another, is H, D (deuterium), F, Cl, CₙF₂ₙ₊₁, CₙF₂ₙ₊₁₋ₘClₘOₖ or CₙF₂ₙ₊₁ₘHₘOₖ, at least one of R⁵, R⁶, X¹ and X² contains F, n is an integer of from 1 to 5, m is an integer of from 0 to 5, 2n+1-m≧0, k is an integer of 0 or 1, and R⁷ and R⁸ may be connected to form a ring.

The fluoropolymer having a fluorinated aliphatic ring structure in its main chain may be one having only one type of repeating unit selected from the above formulae (1) to (5), or one having two or more types selected from the above formulae (1) to (5). Further, the fluoropolymer having a fluorinated aliphatic ring structure in its main chain may be one having a repeating unit selected from the above formulae (1) to (5) and a repeating unit other than the above formulae (1) to (5), specifically a fluorine-containing repeating unit other than one having a fluorinated aliphatic ring structure in its main chain (hereinafter referred to as "another fluorinated repeating unit").

Further, the fluoropolymer having a fluorinated aliphatic ring structure in its main chain is preferably a perfluoropolymer which is considered to have less interactions between polymer molecules. Accordingly, the fluoropolymer having a repeating unit selected from the above formulae (1) to (5) is preferably a perfluoropolymer. Further, among perfluoropolymers, a perfluorohomopolymer is particularly preferred. Thus, the fluoropolymer having a repeating unit selected from the above formulae (1) to (5) is particularly preferably a perfluorohomopolymer.

An example of the fluoropolymer having a repeating unit selected from the above formulae (1) to (5) is a fluoropolymer having a repeating unit formed by cyclopolymerization of a fluoromonomer (a) having at least two polymerizable double bonds. Here, specific examples of the fluoromonomer (a) having at least two polymerizable double bonds include, for example, a perfluoro(butenyl vinyl ether) (CF₂=CFOCF₂CF₂CF=CF₂), perfluoro(allyl vinyl ether) (CF₂=CFOCF₂CF=CF₂), perfluoro(1-methyl-3-butenyl vinyl ether) (CF₂=CFCF₂CF(CF₃)OCF=CF₂), and a non-conjugated diene represented by the following formula:

CFX³=CX⁴OCX⁵X⁶OCX⁴=CX³F

wherein each of X³ and X⁴ is F, Cl or H, and each of X⁵ and X⁶ is F or CF₃.

Further, another example of the fluoropolymer having a repeating unit selected from the above formulae (1) to (5) is a fluoropolymer having a repeating unit formed by polymerizing a fluoromonomer (b) having a fluorinated ring structure. Here, a specific example of the fluoromonomer (b) having a fluorinated ring structure may, for example, be a fluorodioxol represented by the following formula (6):

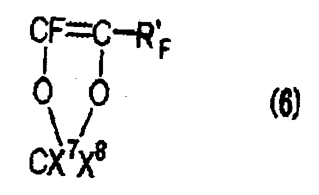

In the above formula (6), R'_{F} is F, R_{F} or OR_{F}, wherein R_{F} is a linear or branched C₁₋₅ perfluoroalkyl group, and each of X⁷ and X⁸ which are independent of each other, is F or CF₃.

In the above formula (6), it is preferred that R'_{F} is OCF₃, and each.of X⁷ and X⁸ is F. Further, it is preferred that R'_{F} is F, and each of X⁷ and X⁸ is CF₃.

Still another example of a fluoropolymer having a repeating unit selected from the above formulae (1) to (5) is a fluoropolymer having a repeating unit formed by cyclopolymerizing a fluoromonomer (a) having at least two polymerizable double bonds and a repeating unit formed by polymerizing a fluoromonomer (b) having a fluorinated ring structure.

As mentioned above, the fluoropolymer having a fluorinated aliphatic ring structure in its main chain may be one having a repeating unit selected from the above formulae (1) to (5) and another fluorinated repeating unit. Here, a specific example of another fluorinated repeating unit may, for example, be a repeating unit obtained by polymerizing a C₂₋₈ perfluoroolefin such as tetrafluoroethylene or hexafluoropropene, a C₂₋₈ chlorofluoroolefin such as chlorotrifluoroethylene, a perfluoro(alkyl vinyl ether) or a perfluoro(alkyloxyalkyl vinyl ether).

The fluoropolymer having a fluorinated aliphatic ring structure in its main chain is more preferably a perfluorohomopolymer composed solely of a repeating unit formed by cyclopolymerizing a fluoromonomer (a) having at least two polymerizable double bonds, particularly preferably a perfluorohomopolymer composed solely of a repeating unit formed by cyclopolymerizing perfluoro(butenyl vinyl ether). CYTOP (registered trademark) manufactured by Asahi Glass Company, Limited may be mentioned as a perfluorohomopolymer composed solely of a repeating unit formed by cyclopolymerizing perfluoro(butenyl vinyl ether).

The reason why the perfluoropolymer composed solely of a repeating unit formed by cyclopolymerizing perfluoro(butenyl vinyl ether) is preferred, is that even in a case where a polymer having an initiator terminal, etc. completely fluorinated and having no functional group, is used, it is possible to obtain a fluoropolymer thin film having a practically sufficient film strength and adhesion to a substrate. This reason is not clearly understood, but it is considered that as is different from a fluoropolymer raw material used in a conventional method for producing a fluoropolymer thin film, even in a case of having a relatively large molecular weight (e.g. a weight average molecular weight at a level of from 3,000 to 80,000), vapor deposition is possible at a low temperature not to cleave the main chain (specifically from 100 to 400°C), and a fluorinated thin film having the same structure as the evaporation source is formed.

The fluoropolymer thin film formed by the present invention has practically sufficient film strength and adhesion to a substrate. However, in order to further improve the adhesion to a substrate, it is preferred to use, as a fluoropolymer having a fluorinated aliphatic ring structure in its main chain, one having a functional group capable of forming a chemical bond to a substrate and/or a functional group capable of forming a chemical bond between molecules of the fluoropolymer. The functional group capable of forming a chemical bond to a substrate may, for example, be preferably a -COF group, a -COOH group, a -NH₂ group, a -COOR group (wherein R is an alkyl group), a SiR_{3-X}(OR)ₓ group (wherein R is an alkyl group, and X is an integer of from 1 to 3), a -SiCl₃ group, a -N=C=O group or -OH group. The alkyl group in the above -COOR group or the SiR_{3-X}(OR)ₓ group preferably has from 1 to 4 carbon atoms. As the functional group capable of forming a chemical bond to a substrate, a -COOH group, a -NH₂ group or a -COOR group is more preferred. Further, the functional group capable of forming a chemical bond between molecules of the fluoropolymer may, for example, be, in addition to the above functional groups, a carbon atom-carbon atom double bond or a carbon atom-carbon bond triple bond.

In a case where the fluoropolymer having a fluorinated aliphatic ring structure in its main chain has a functional group capable of forming a chemical bond to a substrate and/or a functional group capable of forming a chemical bond between molecules of the fluoropolymer, the functional group density varies depending upon the type of the fluoropolymer and the type of the functional group. For example, in a case where a perfluorohomopolymer having a weight average molecular weight of 20,000 composed solely of a repeating unit formed by cyclopolymerizing perfluoro(butenyl vinyl ether), has a -COOH group as a functional group capable of forming a chemical bond to a substrate, the functional group density is preferably from 2.5×10⁻⁶ to 1×10⁻² mol/g. If the functional group density is less than 2.5×10⁻⁶ mol/g, the effect to improve the adhesion to a substrate tends to be poor. On the other hand, if the functional group density exceeds 1×10⁻² mol/g, light absorption by functional groups not contributing to the adhesion to a substrate tends to occur, whereby the transparency of the film will be impaired.

The perfluoropolymer having a fluorinated aliphatic ring structure in its main chain to be used as an evaporation source, has a weight average molecular weight of from 3,000 to 80,000, preferably from 10,000 to 80,000, more preferably from 10,000 to 40,000. If the weight average molecular weight is less than 3,000, no adequate film strength may be obtained for the fluoropolymer thin film thereby formed. On the other hand, if the weight average molecular weight exceeds 80,000, such a polymer will not have a vapor pressure sufficient to provide a practical film forming speed, whereby the evaporation source is required to be heated at a high temperature, specifically at a temperature exceeding 400°C, and the main chain of the fluoropolymer is likely to be cleaved during the vapor deposition process, and the fluoropolymer tends to have a low molecular weight, and the film strength of the fluoropolymer thin film thereby formed, tends to be inadequate. In this respect, Comparative Example 1 in Patent Document 3 shows that a thin film deposited by using CYTOP (registered trademark) manufactured by Asahi Glass Company, Limited as a fluorinated organic substance target to be used for a vapor deposition method, while heating to a temperature of from 250 to 700°C, is inferior in the durability. Although the weight average molecular weight of CYTOP used in Comparative Example 1 is not disclosed in Patent Document 3, the weight average molecular weight of CYTOP (model No.: CTL-A type) having the smallest molecular weight among commercial products is 150,000, and therefore, the weight average molecular weight of CYTOP used in Comparative Example 1 is considered to be at least 150,000. Although CYTOP may be vapor-deposited at a temperature lower than the fluoropolymer raw material used in the conventional method for producing a fluoropolymer thin film, if one having such a large weight average molecular weight is used as an evaporation source, it is required to heat the evaporation source to a high temperature at a level of 700°C, and it is considered that the main chain of the fluoropolymer was cleaved during the vapor deposition process, and the fluoropolymer became to have a low molecular weight, whereby the film strength of the fluoropolymer thin film became inadequate.

In a case where the perfluoropolymer having a fluorinated aliphatic ring structure in its main chain to be used as an evaporation source is a perfluorohomopolymer composed solely of a repeating unit formed by cyclopolymerising perfluoro(butenyl vinyl ether), the intrinsic viscosity [η] in perfluoro(2-butyltetrahydrofuran) at 30°C is preferably from 0.01 to 0.14 dl/g, more preferably from 0.02 to 0.1 dl/g, particularly preferably from 0.02 to 0.08 dl/g. If [η] is less than 0.01 dl/g, the molecular weight of the fluoropolymer becomes relatively small, whereby no adequate film strength can be obtained for the fluoropolymer thin film after forming. On the other hand, if [η] exceeds 0.2 dl/g, the molecular weight of the fluoropolymer becomes relatively large, whereby no adequate vapor pressure to provide a practical film forming speed can be obtained.

### SUBSTRATE

In the present invention, the substrate on which the fluoropolymer thin film is to be formed, may, for example, be a substrate of metal, glass, ceramics or an organic polymer. Such a substrate may be a substrate of e.g. plate form, cylindrical form, spherical form, rod form, block form, plate form, circular form, convex form or concave form. Further, it is possible to suitably use substrates of various shapes, such as substrates having, on their surfaces, a microstructure of from a nanometer order to a micrometer order. Particularly, a substrate having a prescribed fine pattern formed on the substrate surface, or a rectangular substrate having a three dimensional structure on the substrate surface can be preferably used. As a method for forming or processing the substrate, a known method may be used without any particular restriction. Further, on the surface of such a substrate, a copper wiring or a transparent electrically conductive film may, for example, be formed.

In the present invention, in order to increase the adhesion to the fluoropolymer thin film, the substrate surface may be surface-treated prior to forming the fluoropolymer thin film. For such surface treatment, a known method may be used, such as surface treatment with a silane coupling agent or a primer-treating agent, oxidation treatment by ozone or an acid such as sulfuric acid or hydrofluoric acid, surface treatment by plasma, optical cleaning treatment by UV light, polishing by a polishing agent, or physical cleaning treatment such as buffing or wet blasting. Only one of such surface treatments may be used, or two or more of them may be used in combination.

In a case where surface treatment is applied for the purpose of increasing the adhesion with the fluoropolymer, it is preferred that the substrate surface and the fluoropolymer thin film will form chemical bonds by the surface treatment. From such a viewpoint, the above substrate is preferably a substrate made of metal, glass or ceramics and further surface-treated by a silane coupling agent. In a case where the substrate is an organic polymer, surface treatment with a primer treating agent is preferred.

The silane coupling agent is preferably an aminosilane such as 3-aminopropyltriethoxysilane or aminopropylmethyldiethoxysilane having an amino group, or a glycidyl silane such as 3-glycidyloxypropyltrimethoxysilane or glycidyloxypropylmethyldimethoxysilane having a glycidyl group, more preferably an aminosilane. Further, the primer treating agent may, for example, be FS-10 (tradename, manufactured by Shin-Etsu Chemical Co., Ltd.).

The silane coupling agent or the primer-treating agent may be applied by a wet method such as a spin coating method, a casting method or a dipping method, or a dry method such as a vacuum evaporation method.

In the wet method, the silane coupling agent or the primer-treating agent is used as one adjusted to be from 0.001 to 20 mass% by its solvent. The treating method may suitably be selected taking into consideration the thickness and the uniformity of the silane coupling layer or the primer layer, the shape of the object to be coated, etc. It may, for example, be a spin coating method, a dipping method, a potting method, a roll coating method, a bar coating method, a printing method, a die coating method, a curtain flow coating method or a spray coating method.

In the dry method, the silane coupling agent or the primer-treating agent may be used as it is, or may be used as one adjusted to from 0.001 to 20 mass% by its solvent. The treating method may be suitably selected in consideration of e.g. the film thickness and the uniformity of the silane coupling layer or the primer layer, the shape of the object to be coated, etc., but a physical vapor deposition method is suitable.

### PHYSICAL VAPOR DEPOSITION METHOD

As the physical vapor deposition method to be used in the method for producing a fluoropolymer thin film of the present invention, a vacuum evaporation method or a sputtering method may be mentioned, but a vacuum evaporation method is suitably utilized with a view to suppressing elimination of fluorine atoms from the fluoropolymer or suppressing cleavage of the main chain of the fluoropolymer and from the viewpoint of the convenience of the apparatus.

The vacuum evaporation method may further be classified into a resistance heating method, an electron beam heating method, a high frequency induction heating method, a reactive vapor deposition method, a molecular beam expitaxial method, a hot wall vapor deposition method, an ion plating method, a cluster ion beam method, etc. Any one of such methods may be applied. The resistance heating method is suitably used with a view to suppressing elimination of fluorine atoms from the fluoropolymer or suppressing cleavage of the main chain of the fluoropolymer and from the viewpoint of convenience of the apparatus. As the vacuum evaporation apparatus, a known apparatus may be used without any particular restriction.

The film forming conditions vary depending upon the type of the vacuum evaporation method. In the case of a resistance heating method, the degree of vacuum prior to the vapor deposition is preferably at most 1×10⁻³ Pa, more preferably at most 1×10⁻⁴ Pa.

The temperature for heating the evaporation source is not particularly limited so long as it is a temperature which will not cause elimination of fluorine atoms or cleavage of the main chain of the fluoropolymer and at which the fluoropolymer evaporation source has an adequate vapor pressure.

Specifically, it is preferably from 100 to 400°C, more preferably from 150 to 400°C, particularly preferably from 200 to 400°C. If the heating temperature is lower than 100°C, no adequate vapor pressure in order to obtain a practical film-forming rate, may be obtained. On the other hand, if the heating temperature exceeds 400°C, detachment of fluorine atoms or cleavage of the main chain of the fluoropolymer is likely to take place, whereby the performance of the fluoropolymer thin film is likely to be low.

During the vacuum evaporation, the substrate temperature is preferably within a range of from room temperature to 200°C. If the substrate temperature exceeds 200°C, there will be problems such that the material which can be used for the substrate, will be limited, the film forming rate tends to be low, and a defect such as wrinkles, is likely to be formed in the fluoropolymer thin film during cooling due to thermal expansion of the substrate. The substrate temperature is preferably at most 150°C, more preferably at most 100°C.

After forming the fluoropolymer thin film, heat treatment is carried out as the case requires. By the heat treatment, the functional group capable of forming a chemical bond with the substrate and/or the functional group capable of forming a chemical bond between molecules of the fluoropolymer, will sufficiently react, whereby the film strength of the fluoropolymer thin film and the adhesion to the substrate may sometimes be improved. Further, a chemical reaction may proceed between the substrate surface treated with a silane coupling agent or primer and the fluoropolymer thin film, whereby it is possible to improve the film strength of the fluoropolymer thin film and adhesion to the substrate.

The heat treatment condition vary depending upon the type of the substrate, the type of the fluoropolymer and the type of the functional groups, but the heat treatment is preferably carried out in an atmosphere of an inert gas or air at a temperature of from 50 to 200°C. If the heat treatment temperature is lower than 50°C, the heat treatment effect cannot be obtained. On the other hand, if the heat treatment temperature exceeds 200°C, the polymer tends to be melted or softened, whereby the flatness of the thin film tends to be impaired.

### FLUOROPOLYMER THIN FILM

The fluoropolymer thin film of the present invention to be obtained by the above-described procedure, is a thin film made of a fluoropolymer having essentially the same structure as the fluoropolymer of the evaporation source, and its weight average molecular weight is from 3,000 to 80,000. In a case where an evaporation source having a molecular weight distribution is employed, there is a possibility that a fluoropolymer thin film having a weight average molecular weight smaller than the fluoropolymer evaporation source may be formed. However, so long as the weight average molecular weight of the formed fluoropolymer thin film is from 3,000 to 80,000, such a film is excellent in the film strength and adhesion to a substrate.

The thickness of the fluoropolymer thin film of the present invention is preferably at most 100 µm, more preferably at most 10 µm. It takes time to form a film having a thickness exceeding 100 µm, such being not practical, and the adhesion to a substrate tends to be low. The lower limit is not particularly limited, but is preferably 10 nm taking into consideration such a possibility that non-deposited portions (pinholes) may result. The thickness of the fluoropolymer thin film of the present invention is more preferably from 20 nm to 10 µm, further preferably from 20 nm to 2 µm.

### EXAMPLES

Now, the present invention will be described in further detail with reference to Examples. However, it should be understood that the present invention is by no means restricted to such Examples. Preparation Examples 1 to 8 and Examples 1 to 3, 6 to 8 and 10 to 15 are Working Examples of the present invention, and Examples 4, 5 and 9 are Comparative Examples.

### EVALUATION ITEMS, EVALUATION METHODS

### CONTACT ANGLE (CA)

The contact angle of a fluoropolymer thin film was measured by means of a contact angle measuring apparatus (product name: CA-X150, manufactured by Kyowa Chemical Industry Co., Ltd.). It is necessary to measure the contact angle in a state where the surface to be measured is clean. As a method to clean the surface to be measured to be a clean state, a known cleaning method may be used within a range not to damage the surface. For example, solvent cleaning by an organic solvent such as acetone or an alcohol, or optical cleaning by an UV lamp may be mentioned. In Examples 1 to 10, solvent cleaning by acetone was employed.

### WEIGHT AVERAGE MOLECULAR WEIGHT

The weight average molecular weight of a fluoropolymer evaporation source was measured by means of a gel permeation chromatography (GPC). Firstly, a fluoropolymer standard sample having a known molecular weight was measured by means of GPC, and a calibration curve was prepared from the molecular weight and the elution time of the peak top. Then, a fluoropolymer evaporation source was measured, and its molecular weight was obtained from the calibration curve thereby to obtain a weight average molecular weight. As a mobile phase solvent, perfluoro(2-butyltetrahydrofuran) was used.

### FUNCTIONAL GROUP DENSITY

The functional group density of a fluoropolymer evaporation source was measured by means of ¹H-NMR.

### ABRASION RESISTANCE TEST

Using a rubbing tester (tradename, Rubbing TesterA1566, manufactured by lmoto Machinery Co., Ltd.), the surface of the formed vapor deposition film was abraded by reciprocating Kuraflex Screen Wiper (Model No.: VS-30C, manufactured by Kuraray Co., Ltd.) five times under a load of 500 g whereupon the contact angle at the abraded portion was measured.

### PREPARATION OF FLUOROPOLYMER EVAPORATION SOURCE

### PREPARATION EXAMPLE 1

30 g of perfluoro(butenyl vinyl ether), 30 g of 1,1,1,2,2,3,3,4,4,5,5,6,6-tridecafluorohexane, 0.5 g of methanol and 0.44 g of ((CH₃)₂-CH-OCOO)₂ as a polymerization initiator, were put into a glass reactor having an internal capacity of 50 ml. The interior of the system was replaced with high purity nitrogen gas, and then polymerization was carried out at 40°C for 24 hours. The obtained solution was subjected to removal of the solvent under the conditions of 666 Pa (absolute pressure) and 50°C to obtain 28 g of polymer A. The intrinsic viscosity [η] of the polymer A in perfluoro(2-butyltetrahydrofuran) at 30°C was 0.04 dl/g

### PREPARATION EXAMPLE 2

The polymer A was treated with F₂ gas by the method disclosed in JP-A-11-152310 to replace unstable terminal groups with -CF₃ groups thereby to obtain polymer B. The intrinsic viscosity [η] of the polymer B in perfluoro(2-butyltetrahydrofuran) at 30°C was 0.04 dl/g.

The weight average molecular weight of the polymer B was measured by the above-mentioned method, and as a result, it was 20,000. Further, the functional group density was measured by the above-mentioned method, and as a result, the functional group density measurable by ¹H-NMR was lower than the lower detection limit (1×10⁻⁶).

### PREPARATION EXAMPLE 3

The polymer A was subjected to heat treatment in an air at 250°C for 8 hours by the method disclosed in JP-A-04-189880 and then immersed in water to obtain polymer C having -COOH groups. The intrinsic viscosity [η] of the polymer C in perfluoro(2-butyltetrahydrofuran) at 30°C was 0.04 dl/g.

Further, the functional group density was measured by the above-mentioned method, and as a result, the density of -COOH functional groups was 2×10⁻⁴ mol/g.

### PREPARATION EXAMPLE 4

The polymer C was subjected to 3-aminopropyltriethoxysilane treatment by the method as disclosed in JP-A-04-226177 to obtain polymer D having -Si(OC₂H₅)₃ groups. The intrinsic viscosity [η] of the polymer D in perfluoro(2-butyltetrahydrofuran) at 30°C was 0.04 dl/g.

Further, the functional group density was measured by the above-mentioned method, and as a result, the density of -Si(OC₂H₅)₃ functional groups was 2×10⁻⁴ mol/g.

### PREPARATION EXAMPLE 5

The polymer A was subjected to heat treatment in an air at 250°C for 8 hours and then immersed in methanol to obtain polymer E having -COOCH₃ groups. The intrinsic viscosity [η] of the polymer E in perfluoro(2-butyltetrahydrofuran) at 30°C was 0.04 dl/g.

The weight average molecular weight of the polymer B was measured by the above-mentioned method, and as a result, it was 30,000.

Further, the functional group density was measured by the above-mentioned method, and as a result, the density of -COOCH₃ functional groups was 1×10⁻⁴ mol/g.

### PREPARATION EXAMPLE 6

14 g of polymer F was obtained in the same manner as in Preparation Example 1 except that methanol was changed to 0.03 g, and as the polymerization initiator, ((CH₃)₂-CH-OCOO)₂ was changed to 0.44 g. The polymer F was subjected to heat treatment in air at 250°C for 8 hours and then immersed in methanol to obtain polymer G having -COOCH₃ groups. The intrinsic viscosity [η] of the polymer G in perfluoro(2-butyltetrahydrbfuran) at 30°C was 0.14 dl/g.

The weight average molecular weight of the polymer G was measured by the above-mentioned method, and as a result, it was 80,000.

### PREPARATION EXAMPLE 7

5 g of perfluoro(4-methylbutenyl vinyl ether), 5 g of 1,1,1,2,2,3,3,4,4,5,5,6,6-tridecafluorohexane, 0.05 g of methanol and 0.06 g of ((CH₃)₂-CH-OCOO)₂ as a polymerization initiator, were put into a glass reactor having an internal capacity of 100 ml. The interior of the system was replaced with high purity nitrogen gas, and then, polymerization was carried out at 40°C for 48 hours. The obtained solution was subjected to removal of the solvent under conditions of 666 Pa (absolute pressure) and 90°C, to obtain 4 g of polymer H. The intrinsic viscosity [η] of the polymer H in 1,1,1,2,2,3,3,4,4,5,5,6,6-tridecafluorohexane at 30°C was 0.06 dl/g.

### PREPARATION EXAMPLE 8

23 g of perfluoro(butenyl vinyl ether), 5 g of perfluoro-2,2-dimethyl-1,3-dioxol, 30 g of 1,1,1,2,2,3,3,4,4,5,5,6,6-tridecafluorohexane, 0.35 g of methanol and 0.44 g of ((CH₃)₂-CH-OCOO)₂ as a polymerization initiator, were put in a SUS autoclave having an internal capacity of 200 ml. The interior of the system was replaced with high purity nitrogen gas, and then, polymerization was carried out at 40°C for 48 hours. The obtained solution was subjected to removal of the solvent under conditions of 666 Pa (absolute pressure) and 90°C, to obtain 20 g of polymer I. The intrinsic viscosity [η] of the polymer I in 1,1,1,2,2,3,3,4,4,5,5,6,6-tridecafluorohexane at 30°C was 0.05 dl/g. Further, the ratio of perfluoro(butenyl vinyl ether) to perfluoro-2,2-dimethyl-1,3-dioxol contained in the polymer I, measured by ¹⁹F-NMR, was 65:35.

### EXAMPLE 1

Using polymer B and, as a substrate, a precision forming mold (made of SUS316), a fluoropolymer thin film was formed on the substrate by means of a vacuum evaporation apparatus (VPC-410, manufactured by ULVAC). The polymer B was filled in an amount of 3.5 g in an alumina crucible in the vacuum evaporation apparatus, and the interior of the vacuum evaporation apparatus was evacuated to at most 1×10⁻³ Pa. The heater for the crucible wherein the polymer B was placed, was heated at a temperature raising rate of at most 10°C/min, and when the heater temperature exceeded 250°C, the shutter was opened to start film formation on the substrate. When the heater temperature exceeded 400°C, the shutter was closed to terminate the film formation on the substrate. At the termination of the film formation, the temperature of the evaporation source was 350°C.

The contact angle of water on the fluoropolymer thin film was measured by the above-described method, and as a result, the contact angle of water was 103°, whereby it was confirmed that a fluoropolymer thin film was formed on the substrate.

Further, the contact angle of water on the mold surface prior to forming the fluoropolymer thin film was 28°. The adhesion of the film was carried out by a cross-cut tape peeling test, whereby the fluoropolymer thin film showed strong adhesion to the substrate. Further, the transparency of the film was subjected to a sensory evaluation by visual observation, whereby it was found to be a colorless transparent thin film.

### EXAMPLE 2

Vacuum evaporation was carried out in the same manner as in Example 1 except that the polymer C was used instead of the polymer B. The contact angle of water on the substrate surface was measured by the above-described method, and as a result, the contact angle of water was 105°, whereby it was confirmed that a fluoropolymer thin film was formed on the substrate. The adhesion of the film was evaluated by a cross-cut tape peeling test, whereby this fluoropolymer thin film showed strong adhesion to the substrate. Further, the transparency of the film was subjected to a sensory evaluation by visual observation, whereby it was found to be a colorless transparent thin film.

### EXAMPLE 3

Vacuum evaporation was carried out in the same manner as in Example 1 except that the polymer D was used instead of the polymer B. The contact angle of water on the substrate surface was measured by the above-described method, and as a result, the contact angle of water was 105°, whereby it was confirmed that a fluoropolymer thin film was formed on the substrate. The adhesion of the film was evaluated by a cross-cut tape peeling test, whereby this fluoropolymer thin film showed strong adhesion to the substrate. Further, the transparency of the film was subjected to a sensory evaluation by visual observation, whereby it was found to be a colorless transparent thin film.

### EXAMPLE 4

Vacuum evaporation was carried out in the same manner as in Example 1 except that CYTOP (registered trademark) (model No.: CTL-A type, manufactured by Asahi Glass Company, Limited, weight average molecular weight: 150,000) was used instead of the polymer B. The contact angle of water on the substrate surface was measured by the above-described method, and as a result, the contact angle of water was 28°, thus showing that no fluoropolymer thin film was formed on the substrate.

### EXAMPLE 5

Vacuum evaporation was carried out in the same manner as in Example 1 except that instead of the polymer B, CYTOP (registered trademark) (model No.: CTL-A type, manufactured by Asahi Glass Company, Limited, weight average molecular weight: 150,000) was used, and at the time when the heater temperature exceeded 700°C, the shutter was closed to terminate the film formation. The contact angle of water on the substrate surface was measured by the above-described method, and as a result, the contact angle of water was 81°, whereby it was confirmed that a fluoropolymer thin film was formed on the substrate. However, when the transparency of the film was evaluated by a sensory evaluation by visual observation, it was found to be a thin film colored brown. Further, the adhesion of the film was evaluated by a cross-cut tape peeling test, whereby it was readily peeled, and good adhesion was not obtained.

### EXAMPLE 6

3-aminopropyltriethoxysilane dissolved in an amount of 0.05 wt% in a solvent of ethanol/pure water=95/5 (weight ratio) was applied by spin coating on the surface of a precision-forming mold (made of SUS316) substrate. Then, it was naturally dried to apply surface treatment by a silane coupling agent to the substrate surface.

Vacuum evaporation was carried out in the same manner as in Example 1 except that the substrate having the surface treatment carried out by the above procedure was used, and instead of the polymer B, the polymer C was used, and further, heat treatment was carried out in an atmosphere of air at 180°C.

The contact angle of water on the substrate surface was measured by the above-described method, and as a result, the contact angle of water was 109°, whereby it was confirmed that a fluoropolymer thin film was formed on the substrate. The adhesion of the film was evaluated by a cross-cut tape peeling test, whereby this fluoropolymer thin film showed very strong adhesion to the substrate. Further, the transparency of the film was evaluated by a sensory evaluation by visual observation, whereby it was found to be a colorless transparent thin film.

### EXAMPLE 7

Using synthetic quartz glass (tradename: AQQ, manufactured by Asahi Glass Company, Limited) as a substrate, a fluoropolymer thin film was formed on the substrate by means of a vacuum evaporation apparatus. The polymer B was filled in an amount of 1.2 g in a molybdenum boat (tradename: VACOM Mo boat BP-21-0.3t, manufactured by Furuuchi Chemical Corporation) in the vacuum evaporation apparatus, and the interior of the vacuum evaporation apparatus was evacuated to at most 1×10⁻³ Pa. An electric current of 60 A was applied to the molybdenum boat filled with the polymer B for heating thereby to melt the polymer B filled in the boat. Then, the electric current was adjusted so that the film forming rate by a quartz oscillator film thickness meter would be 0.3 nm/sec, and then the shutter was opened to carry out film formation at a film forming rate of 0.3 nm/sec. When the film thickness by a quartz oscillator film thickness meter became 1.2 µm, the shutter was closed to stop heating of the boat thereby to terminate film formation.

The contact angle of water on a fluoropolymer thin film was measured by the above-described method, and as a result, the contact angle of water was 114°, whereby it was confirmed that a fluoropolymer thin film was formed on the substrate.

Further, the contact angle of water on a synthetic quartz glass surface prior to forming the fluoropolymer thin film was 21°. Further, the transparency of the film was evaluated by a sensory evaluation by visual observation, whereby it was found to be a colorless transparent thin film. Further, the abrasion resistance test of the fluoropolymer thin film was carried out by the above-described method, whereby the contact angle after the abrasion resistance test was 100°, and thus, this fluoropolymer thin film on the substrate showed strong abrasion resistance.

The molecular structure of the polymer B and the polymer structure of the fluoropolymer thin film obtained were measured by ¹⁹F-NMR, whereby the molecular structures of the polymer B and the fluoropolymer thin film were exactly the same. That is, there was no elimination of fluorine atoms or no cleavage of the main chain of the fluoropolymer during the film forming.

### EXAMPLE 8

Vacuum evaporation was carried out in the same manner as in Example 7 except that a float glass of 3 mm (manufactured by Asahi Glass Company, Limited) was used as the substrate, the polymer C was used instead of the polymer B, the film forming rate by the quartz oscillator was adjusted to be a film forming rate of 0.1 nm/sec, and the shutter was closed when the film thickness by the quartz osscillator film thickness meter became 500 nm, and further, heat treatment was caried out in an atmosphere of air at 200°C.

The contact angle of water on a fluoropolymer thin film was measured by the above-described method, and as a result, the contact angle of water was 106°, whereby it was confirmed that a fluoropolymer thin film was formed on the substrate.

Further, the contact angle of water on the surface of the float glass of 3 mm prior to forming the fluoropolymer thin film was 24°. Further, the transparency of the film was evaluated by visual observation, whereby it was found to be a colorless transparent thin film. Further, the abrasion resistance test of the fluoropolymer thin film was carried out by the above-described method, whereby the contact angle after the abrasion resistance test was 70°, and thus, this fluoropolymer thin film on the substrate showed fairly strong abrasion resistance.

### EXAMPLE 9

Vacuum evaporation was carried out in the same manner as in Example 7 except that a float glass of 3 mm (manufactured by Asahi Glass Company, Limited) was used as the substrate, CYTOP (registered trademark) (model No.: CTL-S type, manufactured by Asahi Glass Company, Limited, weight average molecular weight: 150,000) was used instead of the polymer B, and the film forming rate by the quartz oscillator was adjusted to be a film forming rate of 0.1 nm/sec, and when the film thickness by the quartz osscillator film thickness meter became 500 nm, the shutter was closed.

The contact angle of water on a fluoropolymer thin film was measured by the above-described method, and as a result, the contact angle of water was 108°, whereby it was confirmed that a fluoropolymer thin film was formed on the substrate.

Further, the transparency of the film was evaluated by visual observation, whereby it was found to be a film colored brown. Further, on the film, deposition of fine powdery substance was observed, and it was considered that CYTOP as the evaporation source was decomposed during the film forming, and the decomposed product was re-bonded to form a film. Further, the abrasion resistance test of the fluoropolymer thin film was carried out by the above-described method, whereby the contact angle after the abrasion resistance test was 45°, and this fluoropolymer thin film on the substrate was readily peeled and did not show abrasion resistance.

### EXAMPLE 10

3-Aminopropyltriethoxysilane dissolved in an amount of 0.05 wt% in a solvent of ethanol/pure water=95/5 (weight ratio), was applied by spin coating on the surface of a substrate of float glass of 3 mm. Then, it was naturally dried to carry out the surface treatment by a silane coupling agent to the substrate surface.

Vacuum evaporation was carried out in the same manner as in Example 8 except that the substrate surface-treated by the above procedure, was used, and further, heat treatment was carried out in an atmosphere of air at 200°C.

The contact angle of water on the fluoropolymer thin film was measured by the above-described method, and as a result, the contact angle of water was 100°. Thus, it was confirmed that a fluoropolymer thin film was formed on the substrate. Further, the transparency of the film was evaluated by visual observation, whereby it was found to be a colorless transparent thin film. Further, the abrasion resistance test of the fluoropolymer thin film was carried out by the above-described method, whereby the contact angle after the abrasion resistance test was 106°. The above abrasion resistance test was further repeated to carry out a total of 100 cycles of the abrasion resistance test, whereupon the contact angle was measured, whereby the contact angle after 100 cycles of the abrasion resistance test was 102°, and this fluoropolymer thin film on the substrate showed very strong abrasion resistance.

### EXAMPLE 11

3-Aminopropyltriethoxysilane was filled in an amount of 2 ml in a molybdenum boat (tradename: VACOM Mo boat BP-21-0.3t, manufactured by Furuuchi Chemical Corporation) in the vacuum evaporation apparatus, and then, the interior of the vacuum evaporation apparatus was evacuated to at most 1 Pa, to permit 3-aminopropyltriethoxysilane vapor to contact with the surface of the substrate of float glass of 3 mm thereby to carry out surface treatment by a silane coupling agent to the substrate surface.

Vacuum evaporation was carried out in the same manner as in Example 7 except that the substrate having the surface treatment carried out by the above procedure was used as the substrate, the polymer E was used instead of the polymer B, the film forming rate by the quartz oscillator was adjusted to a film forming rate of 0.2 nm/sec, and when the film thickness by the quartz oscillator film thickness meter became 720 nm, the shutter was closed.

The contact angle of water on the fluoropolymer thin film was measured by the above-described method, and as a result, the contact angle of water was 104°. Thus, it was confirmed that a fluoropolymer thin film was formed on the substrate. Further, the transparency of the film was evaluated by visual observation, whereby it was found to be a colorless transparent thin film. Further, the abrasion resistance test of the fluoropolymer thin film was carried out by the above-described method, whereby the contact angle after the abrasion resistance test was 103°. The above abrasion resistance test was further repeated, and the contact angle after carrying out a total of 100 cycles of the abrasion resistance test, was measured, whereby the contact angle after 100 cycles of the abrasion resistance test was 103°, and this fluoropolymer thin film on the substrate showed very strong abrasion resistance.

### EXAMPLE 12

Vacuum evaporation was carried out in the same manner as in Example 7 except that the polymer G was used instead of the polymer B, and the film forming rate by a quartz oscillator was adjusted to be a film forming rate of 0.04 nm/sec, and when the film thickness by the quartz oscillator film thickness meter became 440 nm, the shutter was closed.

The contact angle of water on the fluoropolymer thin film was measured by the above-described method, and as a result, the contact angle of water was 107°, and it was confirmed that a fluoropolymer thin film was formed on the substrate.

Further, the transparency of the film was visually evaluated, and it was found to be a colorless transparent thin film. Further, the abrasion resistance test of the fluoropolymer thin film was carried out by the above-described method, whereby the contact angle after the abrasion resistance test was 93°, and this fluoropolymer thin film on the substrate showed strong abrasion resistance.

### EXAMPLE 13

Vacuum evaporation was carried out in the same manner as in Example 11 except that the polymer G was used instead of the polymer E, and the film forming rate by a quartz oscillator was adjusted to be a film forming rate of 0.04 nm/sec, and when the film thickness by the quartz oscillator film thickness meter became 440 nm, the shutter was closed.

The contact angle of water on the fluoropolymer thin film was measured by the above-described method, and as a result, the contact angle of water was 107°. It was confirmed that a fluoropolymer thin film was formed on the substrate. Further, the transparency of the film was visually evaluated, and it was found to be a colorless transparent thin film. Further, the abrasion resistance test of the fluoropolymer thin film was carried out by the above-described method, whereby the contact angle after the abrasion resistance test was 109°, and this fluoropolymer thin film on the substrate showed strong abrasion resistance.

### EXAMPLE 14

Vacuum evaporation was carried out in the same manner as in Example 7 except that the polymer H was used instead of the polymer B, the film forming rate by the quartz oscillator was adjusted to be a film forming rate of 0.05 nm/sec, and when the film thickness by the quartz oscillator film thickness meter became 500 nm, the shutter was closed. The contact angle of water on the substrate surface was measured by the above-described method, and as a result, the contact angle of water was 111°, whereby it was confirmed that a fluoropolymer thin film was formed on the substrate. Further, the transparency of the film was evaluated by a sensory evaluation by visual observation, whereby it was found to be a colorless transparent thin film.

### EXAMPLE 15

Vacuum evaporation was carried out in the same manner as in Example 11 except that the polymer I was used instead of the polymer B, and the film forming rate by a quartz oscillator was adjusted to be a film forming rate of 0.05 nm/sec, and when the film thickness by the quartz oscillator film thickness meter became 500 nm, the shutter was closed.

The contact angle of water on the fluoropolymer thin film was measured by the above-described method, and as a result, the contact angle of water was 113°. It was confirmed that a fluoropolymer thin film was formed on the substrate. Further, the transparency of the film was visually evaluated, and it was found to be a colorless transparent thin film. Further, the above-described method was repeated, and the contact angle after carrying out a total of 100 cycles of the abrasion resistance test, was measured, whereby the contact angle after 100 cycles of the abrasion resistance test was 110°, and the fluoropolymer thin film on the substrate showed strong abrasion resistance.

### INDUSTRIAL APPLICABILITY

The fluoropolymer thin film obtainable by the present invention can be suitably used for e.g. a water and oil repellent coating, a low reflection coating, an antifouling coating, a non-adhesive coating, a water-proof/moisture-proof coating, an insulation film, a chemical resistance coating, an etching/protective film, a low refractive index film, an ink repellent coating, a gas barrier film or a patterned functional film.

More specifically, it can be suitably used for e.g. a surface protective film for a display color filter, an antifouling/antireflection film for a solar cell cover glass, a moisture preventive/antireflection coating for deliquescent crystal or phosphate glass, a surface protective/antifouling coating for a phase shift mask or photomask, a liquid repellent coating of a photoresist for immersion lithography, a release coating of contact lithomask, a release coating of nanoimprinting mold, a passivation film for semiconductor element or integrated circuit, a gas barrier film for a circuit board or silver electrodes for an emission electrode such as LED, a liquid crystal alignment film for a liquid crystal display device, a lubricating coating for a magnetic recording medium, a gate insulating film, a device using an electrowetting principle, an electrolet film, a chemical resistance coating for MEMS process, an antifouling coating of medical equipments, chemical resistant/antifouling/bioresistance/water repellent coating for a device utilizing a microfull index technique, a low refractive index material for an optical filter multilayer film coating, a water repellent material for a hydrophilic water repellent patterning, or a patterned optical element.

The entire disclosures of Japanese Patent Application No. 2007-112141 filed on April 20, 2007 and Japanese Patent Application No. 2007-241155 filed on September 18, 2007 including specifications, claims, drawings and summaries are incorporated herein by reference in their entireties.

## Claims

1. A method for producing a fluoropolymer thin film, which comprises forming a fluoropolymer thin film on a substrate by a physical vapor deposition method using, as an evaporation source, a fluoropolymer having a fluorinated aliphatic ring structure in its main chain and having a weight average molecular weight of from 3,000 to 80,000.

2. The method for producing a fluoropolymer thin film according to Claim 1, wherein the fluoropolymer having a fluorinated aliphatic ring structure in its main chain is a fluoropolymer having a repeating unit selected from the following formulae (1) to (5): 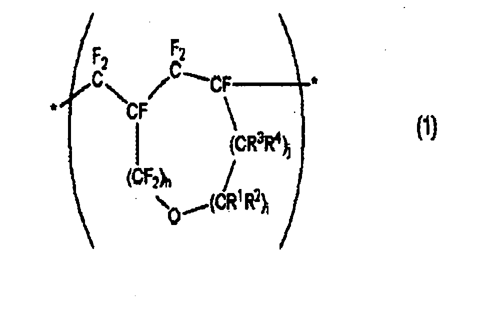 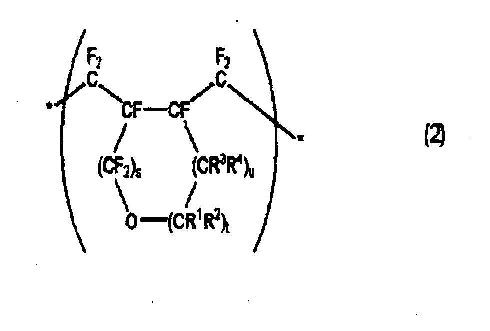 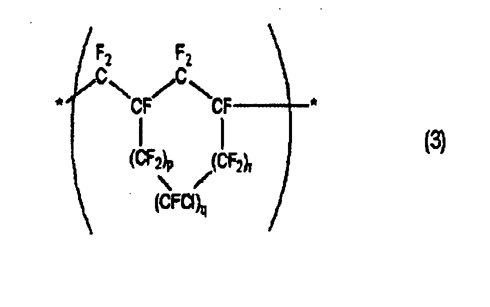 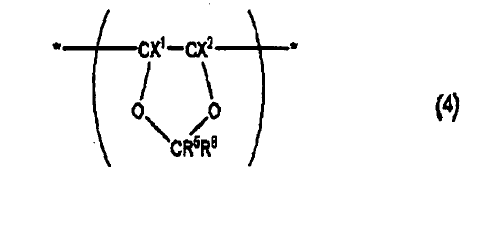 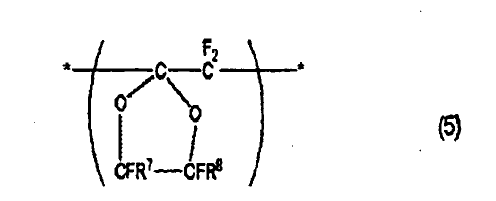 in the formulae (1) to (5), h is an integer of from 0 to 5, i is an integer of from 0 to 4, j is 0 or 1, h+i+j is from 1 to 6, s is an integer of from 0 to 5, t is an integer of from 0 to 4, u is 0 or 1, s+t+u is from 1 to 6, each of p, q and r which are independent of one another, is an integer of from 0 to 5, p+q+r is from 1 to 6, each of R¹, R², R³, R⁴, X¹ and X² which are independent of one another, is H, D (deuterium), F, Cl, OCF₃ or CF₃, each of R⁵, R⁶, R⁷ and R⁸ which are independent of one another, is H, D (deuterium), F, Cl, CₙF₂ₙ₊₁, CₙF₂ₙ₊₁₋ₘClₘOₖ or CₙF₂ₙ₊₁₋ₘHₘOₖ, at least one of R⁵, R⁶, X¹ and X² contains F, n is an integer of from 1 to 5, m is an integer of from 0 to 5, 2n+1-m≧0, k is an integer of 0 or 1, and R⁷ and R⁸ may be connected to form a ring.

3. The method for producing a fluoropolymer thin film according to Claim 1 or 2, wherein the fluoropolymer having a fluorinated aliphatic ring structure in its main chain is a perfluoropolymer.

4. The method for producing a fluoropolymer thin film according to any one of Claims 1 to 3, wherein the fluoropolymer having a fluorinated aliphatic ring structure in its main chain has a -COF group, a -COOH group, a -NH₂ group, a -COOR group (wherein R is an alkyl group), SiR_{3-X}(OR)_{X} group (wherein R is an alkyl group and X is an integer of from 1 to 3), a -SiCl₃ group, a -N=C=O group or a -OH group, as a functional group capable of forming a chemical bond to a substrate.

5. The method for producing a fluoropolymer thin film according to Claim 3, wherein the perfluoropolymer is a perfluorohomopolymer.

6. The method for producing a fluoropolymer thin film according to any one of Claims 1 to 5, wherein the fluoropolymer having a fluorinated aliphatic ring structure in its main chain is a perfluorohomopolymer composed solely of repeating units formed by cyclopolymerization of a perfluoro(butenyl vinyl ether).

7. The method for producing a fluoropolymer thin film according to any one of Claims 1 to 6, wherein the fluoropolymer having a fluorinated aliphatic ring structure in its main chain is any one of the following fluoropolymers (I) to (V):
(I)a fluoropolymer having repeating units formed by cyclopolymerization of a fluoromonomer (a) having at least 2 polymerizable double bonds,
(II) a fluoropolymer having repeating units formed by polymerization of a fluoromonomer (b) having a fluorinated ring structure,
(III) a fluoropolymer having repeating units formed by cyclopolymerization of the above fluoromonomer (a) and repeating units formed by polymerization of the above fluoromonomer (b),
(IV) a fluoropolymer having repeating units formed by cyclopolymerization of the above fluoromonomer (a) and repeating units formed by polymerization of a fluoromonomer (c) other than the above fluoromonomer (a) or (b), and
(V) a fluoropolymer having repeating units formed by polymerization of the above fluoromonomer (b) and repeating units formed by polymerization of a fluoromonomer (c) other than the above fluoromonomer (a) or (b).

8. The method for producing a fluoropolymer thin film according to any one of Claims 1 to 7, wherein the substrate is a substrate made of metal, glass or ceramics and surface-treated by a silane coupling agent.

9. The method for producing a fluoropolymer thin film according to any one of Claims 1 to 8, wherein the physical vapor deposition method is a vacuum evaporation method.

10. The method for producing a fluoropolymer thin film according to Claim 9, wherein in the vacuum evaporation method, the heating temperature of the evaporation source is within a range of from 100 to 400°C.

11. A fluoropolymer thin film having a thickness of from 10 nm to 100 µm, obtainable by the method for producing a fluoropolymer thin film as defined in any one of Claims 1 to 10.
